# EUROPEAN PATENT SPECIFICATION

(11) **EP 2 474 012 B1**
(45) Date of publication and mention of the grant of the patent: **23.10.2019**
(21) Application number: 10749840.4
(22) Date of filing: 30.08.2010
(51) Int. Cl.: H01G 9/20, C23C 18/44

(54) **LOW TEMPERATURE PLATINISATION FOR DYE-SENSITISED SOLAR CELLS**
NIEDRIGTEMPERATUR-PLATINIERUNG FÜR FARBSTOFFSENSIBILISIERTE SOLARZELLEN
INCORPORATION DE PLATINE BASSE TEMPÉRATURE DESTINÉE À DES CELLULES SOLAIRES À COLORANT

(30) Priority: 02.09.2009 GB 0915251
(43) Date of publication of application: 11.07.2012
(73) Proprietor: Bangor University, Gwynedd LL57 2DG (GB)
(72) Inventor: HOLLIMAN, Peter, Gwynedd LL32 8NW (GB); KETIPEARACHCHI, Udaya, Gwynedd LL57 1PH (GB); ANTHONY, Rosie, Conwy Gwynedd LL29 8SE (GB); FATTORI, Alberto, 61122 Pesaro (PU) (IT); CONNELL, Arthur, Gwynedd LL57 3EL (GB)
(74) Representative: Appleyard Lees IP LLP
(86) International application number: PCT/EP2010/062648
(87) International publication number: WO 2011/026812

(56) References cited:
- EP-A1- 1 857 180
- WO-A1-97/15959
- WO-A2-2008/053464
- JP-A- 2002 298 936
- US-A- 3 698 939
- US-A1- 2006 005 876

## Description

### BACKGROUND OF THE INVENTION.

### 1. Field of the invention.

This invention relates to a method for the low temperature platinisation of the counter-electrode of a dye-sensitised solar cell (DSSC) which is applicable to a wide range of substrates.

### 2. Description of the related art.

Solar cells are traditionally prepared using solid state semiconductors. Cells are prepared by juxtaposing two doped crystals, one with a slightly negative charge, thus having additional free electrons (n-type semiconductor) and the other with a slightly positive charge, thus lacking free electrons (p-type semiconductor). When these two doped crystals are put into contact with each other, extra electrons from the n-type semiconductor flow through the n-p junction to reduce the lack of electrons in the p-type semiconductor. At the p-n junction, charge carriers are depleted on one side and accumulated on the other side thereby producing a potential barrier. When photons produced by sunlight strike the p-type semiconductor, they induce transfer of electrons bound in the low energy levels to the conduction band where they are free to move. A load is placed across the cell in order to transfer electrons, through an external circuit, from the p-type to the n-type semiconductor. The electrons then move spontaneously to the p-type material, back to the low energy level they had been extracted from by solar energy. This motion creates an electrical current.

Typical solar cell crystals are prepared from silicon because photons having frequencies in the visible light range have enough energy to take electrons across the band-gap between the low energy levels and the conduction band. One of the major drawbacks of these solar cells is that the most energetic photons in the violet or ultra-violet frequencies have more energy than necessary to move electrons across the band-gap, resulting in considerable waste of energy that is merely transformed into heat. Another important drawback is that the p-type layer must be sufficiently thick in order to have a chance to capture a photon, with the consequence that the freshly extracted electrons also have a chance to recombine with the created holes before reaching the p-n junction. The maximum reported efficiencies of the silicon-type solar cells are thus of 20% to 25% or lower for solar cell modules, due to losses in combining individual cells together.

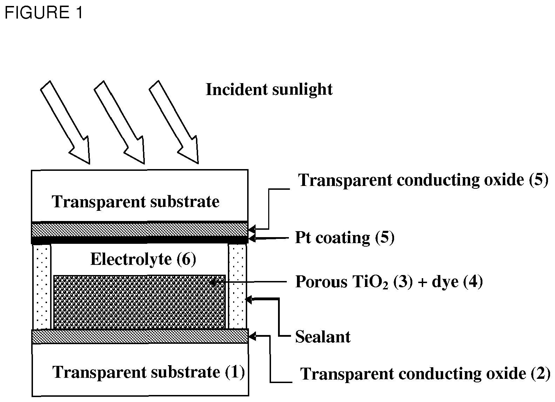

Another important problem of the silicon-type solar cell is the cost in terms of monetary price and also in terms of embodied energy, that is the energy required to manufacture the devices. Dye-sensitised solar cells (DSSC) have been developed in 1991 by O'Regan and Grätzel (O'Regan B. and Grätzel M., in Nature, 1991, 353, 737-740). They are produced using low cost material and do not require complex equipment for their manufacture. They separate the two functions provided by silicon: the bulk of the semiconductor is used for charge transport and the photoelectrons originate from a separate photosensitive dye. The cells are sandwich structures as represented in Figure 1 and are typically prepared by the steps of:
a) providing a transparent plate (1) prepared from glass or from plastic;
b) coating this plate with a transparent conducting oxide (TCO) (2), preferably with doped tin oxide;
c) applying a paste of metal oxide (3), generally titanium dioxide, to the coated glass plate on the TCO side;
d) heating the plate to a temperature of about 450 to 500 °C for a period of time of at least one hour;
e) soaking the coated plate of step d) in a dye solution for a period of time of about 24 hours in order to covalently bind the dye to the surface of the titanium dioxide (4);
f) providing another TCO coated transparent plate further coated with platinum (5);
g) sealing the two glass plates and introducing an electrolyte solution (6) between said plates in order to encase the dyed metal oxide and electrolyte between the two conducting plates and to prevent the electrolyte from leaking.

In these cells, photons strike the dye moving it to an excited state capable of injecting electrons into the conducting band of the titanium dioxide from where they diffuse to the anode. The electrons lost from the dye/TiO₂ system are replaced by oxidising the iodide into triiodide at platinised counter electrode, whose reaction is sufficiently fast to enable the photochemical cycle to continue. Platinum coating the counter electrode catalyses the reduction of the iodide/triodide redox couple; if Pt is not present the efficiency of the cell is severely limited.

The DSSC generate a maximum voltage comparable to that of the silicon solar cells, of the order of 0.7 V. An important advantage of the DSSC, as compared to the silicon solar cells, is that they inject electrons in the titanium dioxide conduction band without creating electron vacancies nearby, thereby preventing quick electron/hole recombinations. They are therefore able to function in low light conditions where the electron/hole recombination becomes the dominant mechanism in the silicon solar cells. The present DSSC are however not very efficient in the lower part of the visible light frequency range in the red and infrared region, because these photons do not have enough energy to cross the titanium dioxide band-gap or to excite most traditional ruthenium bipyridyl dyes.

A major disadvantage of the prior art DSSC resides in the high temperature necessary for depositing and calcining the platinum on the counter electrode. The high temperature needed for sintering the metal oxide paste used on the photoelectrode is also a problem. Another drawback of the dye-sensitised solar cells lies in the long time necessary to dye the titanium dioxide nanoparticles: it takes between 12 and 24 hours to dye the layer of titanium dioxide necessary for solar cell applications. Another major difficulty with the DSSC is the electrolyte solution: the cells must be carefully sealed in order to prevent liquid electrolyte leakage and therefore cell deterioration In classical solar cells preparation, the heat necessary for the decomposition of [PtCl₆]²⁻ is of about 400 ºC. Such high temperature limits the nature of transparent material useable for the substrate to glass. If the temperature can be brought down to at most 150 ºC, transparent polymers such as polyethylene terephthalate (PET) or polyethylene napthalate (PEN) can also be used.

There is thus a need for a method of preparing robust solar cells that can be prepared rapidly at reduced cost.

### SUMMARY OF THE INVENTION.

It is an aim of the present invention to reduce the temperature necessary for the deposition and calcination of the platinum particles coating the counter electrode of dye-sensitised solar cells.

It is another aim of the present invention to ensure good adhesion of platinum particles to the substrate.

It is also an aim of the present invention to produce high transparency for the deposited platinum layer

It is a further aim of the present invention to ensure even coverage of the platinum layer on the widest range of conducting substrates.

In accordance with the present invention, the foregoing aims are realised as defined in the independent claim 1. Preferred embodiments are defined in the dependent claims.

### BRIEF DESCRIPTION OF THE DRAWINGS.

Figure 1 is a schematic representation of a dye-sensitised solar cell.

### DESCRIPTION OF THE PREFERRED EMBODIMENTS.

Accordingly, the present invention discloses a method for low temperature platinisation of the the counter electrode of dye-sensitised solar cells that comprises the steps of:
a) providing a counter electrode prepared from an electro-conducting substrate;
b) coating the counter electrode of step a) with one or more layers of a transparent conducting oxide;
c) cleaning the counter-electrode of step b) with an organic solvent optionally along with ultra-sound;
d) activating the counter electrode of step c) with a solution containing a metal salt and reducing said metal salt on the counter-electrode surface;
e) treating the electrode from step d) with aqueous platinum solution of either Pt (II) or Pt(IV), said solution having a pH of at least 3;
f) adding a reducing agent and wherein the reduction of the aqueous platinum solution is carried out at a temperature of from room temperature to at most 100 °C;
g) retrieving the platinum coated counter electrode, characterised in that all the steps are carried out at a temperature of less than 100°C.

Platinisation of the counter-electrode is an important step in the preparation of the dye-sensitised solar cells. The platinum catalyses electron transfer from the counter electrode to the iodide/triiodide redox couple which, in turn, regenerates the ground state dye from its excited state. Without an efficiently platinised counter electrode, DSSC device efficiencies are very severely limited.

In the prior art, platinisation of the counter-electrode is carried out by the application of an aqueous solution of hexachloro-platinate(IV) followed by heating to 400°C for at least 30 minutes. This is suitable for the application of platinum to counter electrodes prepared from transparent conducting oxide (TCO) coated glass but not to temperature sensitive substrates such as polymers.

The electroconducting substrate or counter electrode can be prepared from transparent glass or polymer selected for example from a polyester based film
such as polyethylene naphthalate (PEN) or polyethylene terephthalate (PET).

it can also be prepared from an opaque substrate such as aluminium, titanium or steel. Preferably it is conducting and transparent and preferably it is prepared from TCO-coated glass, more preferably from TCO-coated polymer.

The transparent conducting oxide (TCO) is preferably zinc oxide doped with aluminium or fluorine, or it is cadmium stannate, or it is tin oxide, more preferably, tin oxide doped with fluorine, indium or antimony, preferably it is doped with fluorine or indium. Several layers of conducting oxide can be applied to the counter-electrode.

In addition, one or more layers of titania particles having a diameter ranging between 300 and 500 nm, preferably about 400 nm, can further be added as scattering layer. This scattering layer further improves the cell efficiency.

The organic solvent used as cleaning solution from step c) has the additional role of reducing the surface tension of the TCO to increase surface wettability and interactions with subsequent aqueous solutions. It is selected from acetone, ethanol or diethyl ether or from aqueous solutions of hydrochloric acid, ammonium hydroxide, sodium hydroxide, potassium hydroxide or ammonia/hydrogen peroxide. Preferably it is aqueous ammonia/hydrogen peroxide. The cleaning solution has the additional effect of removing any surface material from the TCO surface. The cleaning step is carried out at a temperature between 20 and 80°C for a period of time of 3 to 5 minutes. The substrate is preferably placed face down in the solution in order to ensure that oxygen is kept in contact with the substrate's surface.

An optional pre-treatment of step e) can be included. It is preferably carried out with an aqueous tin(II) chloride solution or an aqueous zinc (II) chloride, tin (11) chloride being preferred.

The activation of step d) improves platinum nucleation on the electrode surface and reduces the production of Pt particles in solution. It can advantageously be carried out with a solution of water and isopropanol containing a metal salt selected from PdCl₂ or NiCl₂ or CuCl₂, preferably PdCl₂. It is important to control the pH of this solution to ensure that it is not too low. The pH can be controlled by the addition of a base such as sodium hydroxide, ammonium hydroxide, potassium hydroxide or a buffer solution to keep a pH of at least 3 but preferably of at most 7.

The activating agent is preferably reduced after it has been applied to the surface. The reducing agent is preferably selected from citrate, hydrazine, phosphate hydride, hydrogen or borohydride. More preferably, it is hydrazine, phosphate hydride or hydrogen. Most preferably, it is hydrogen. It is carried out at a temperature between room temperature and 100°C. More preferably it is carried out at room temperature as it replaces the alternative standard heat treatment at 400°C. This extends the range of possible substrates to include polymeric materials such as PEN or PET which are thermally unstable above 150°C.

The aqueous platinum solution is selected from potassium hexachloroplatinate (II), potassium hexachloroplatinate (IV), hexachloroplatinic acid (IV), hexahydroxoplatinate, or a hexahaloplatinate salt such as a hexafluoroplatinate salt, preferably potassium hexachloroplatinate (IV). It is important to control the pH of this solution to ensure that it is not too low. The pH can be controlled by the addition of a base such as sodium hydroxide, ammonium hydroxide, potassium hydroxide or a buffer solution to keep a pH of at least 3 but preferably of at most 7.

The reducing agent from step f) is preferably selected from citrate, hydrazine, phosphate hydride, hydrogen or borohydride. More preferably, it is hydrazine, phosphate hydride or hydrogen. Most preferably, it is hydrogen. It is carried out at a temperature between room temperature and 100°C. More preferably it is carried out at room temperature as it replaces the alternative standard heat treatment at 400°C. This extends the range of possible substrates to include polymeric materials such as PEN or PET, which are thermally unstable above 150°C.

In the present invention, a series of substrate pre-treatment steps are included to clean the substrate surface, to wet the TCO surface to enhance interactions between aqueous solutions and the TCO surface, to improve nucleation of platinum particles on the TCO surface, to improve the efficiency of platinum deposition on the TCO surface over Pt particle formation within solution, to ensure even coverage of Pt over the TCO surface and to improve adhesion of the Pt particles to the TCO-coated counter electrode. Reduction of the platinum precursor in solution is then carried out at a temperature of at most 100 ºC, preferably of at most 90 ºC. The thermal treatment is followed by cooling, down to room temperature. The counter electrode is then ready for DSSC device manufacture.

The cleaning, activation, reduction and deposition processes can all be carried out rapidly in less than 3 to 5 minutes for each step, at room temperature. Increasing the cleaning, activation and deposition time can further decrease the platinisation temperature required and vice versa. In an alternative process, cleaning, activation, reduction and deposition can be assisted by exposure to ultra-violet or microwave radiation. The microwave radiation, if present, can be provided by a commercial or a conventional microwave oven, the commercial oven being preferred because it delivers a constant radiation. The power ranges between 600 and 1000 watts, preferably, it is of about 800 watts.

The platinum layer applied to the counter-electrode using the method of the present invention is very thin, very transparent and very homogeneous contrary to that of the prior art. The platinum particles have a size ranging between 5 and 20 nm.

The substrates can be cleaned, activated, reduced and chemicals deposited thereupon by dipping or spraying followed by wiping to remove excess solution.

The temperature is held at less than 100 ºC throughout the entire process.

In a particularly preferred embodiment according to the present invention the platinisation of the counter-electrode comprises the steps of:
i. cleaning the substrate coated with transparent conducting oxide (TCO) with a solution of ammonia and hydrogen peroxide in distilled water at 70ºC for 3 minutes;
ii. activating the surface of the clean TCO-coated substrate by immersing in a 1:2 (v/v) solution of water and isopropanol containing PdCl₂ and HCI for a period of time of 5 minutes
iii. bubbling hydrogen gas through a solution of isopropanol for a period of time of 30 seconds
iv. dipping the PdCl₂ coated TCO-coated substrate into the hydrogen containing isopropanol solution for a period of time of 3 minutes to reduce Pd²⁺ to Pd
v. immersing the Pd-coated TCO-coated substrate from step iv) in an aqueous solution of a soluble platinum salt such as potassium hexachloroplatinate;
vi. bubbling hydrogen gas through the platinum solution from step v. for a period of time of 1 minute and leaving to stand for a period of time of 3 minutes
vii. washing the platinum coated substrate in deionised water and leaving to dry in air

Dye-sensitised solar cells are then prepared according to any method known in the art. They have a better efficiency and fill factor than those of the prior art when prepared at low temperature and they can use polymers as a substrate. Preferably they are prepared according to a fast-dyeing method and/or a low temperature sintering method.

According to the preferred method, dye-sensitised solar cells are prepared by the steps of:
a) providing a first electrode prepared from an electro-conducting substrate;
b) preparing a colloid comprising at least one semiconducting metal oxide selected for example from titanium dioxide or zinc oxide, a solvent, at least one binder and optionally an adhesion and/or a flocculating agent;
c) adding from more than zero up to 20 wt%, based on the weight of the metal oxide, of a thermal catalyst to the colloid of step b);
d) optionally pre-treating the first electrode with a metal oxide precursor such as TiCl₄ or titanium isopropoxide to aid adhesion;
e) applying the composition of step c) to the conducting side of the first electrode;
f) heating the coated electrode to a temperature of at most 300 ºC for sintering the metal oxide(s);
g) optionally post-treating the metal oxide film with a metal oxide precursor such as TiCl₄ or titanium isopropoxide and sintering again to not more than 300 ºC;
h) providing a second electrode, the counter-electrode, prepared from a transparent substrate coated with a transparent conducting oxide and additionally coated with platinum by the following procedure:
   i. cleaning the transparent conducting oxide (TCO) coated substrate with a solution of ammonia and hydrogen peroxide in distilled water at 70ºC for 3 minutes;
   ii. activating the surface of the clean TCO-coated substrate by immersing in a 1:2 (v/v) solution of water and isopropanol containing PdCl₂ and HCI for a period of time of 5 minutes
   iii. bubbling hydrogen gas through a solution of isopropanol for a period of time of 30 seconds
   iv. dipping the PdCl₂ coated TCO-coated substrate into the hydrogen containing isopropanol solution for a period of time of 3 minutes to reduce Pd²⁺ to Pd
   v. immersing the Pd-coated TCO-coated substrate from step h, iv) in an aqueous solution of a soluble platinum salt such as potassium hexachloroplatinate;
   vi. bubbling hydrogen gas through the platinum solution from step h, v) for a period of time of 1 minute and leaving to stand for a period of time of 3 minutes
   vii. washing the platinum coated substrate in deionised water and leaving to dry in air
i) optionally pre-dyeing the first electrode coated with metal oxide of step e) with a solution comprising one or more dyes in order to covalently bind said dye(s) to the surface of the metal oxide;
j) piercing at least two perforations in the first and/or second electrodes and sealing said electrodes together with glue or with a thermoplastic polymer;
k) pumping one or more solution(s) comprising the same one or more dyes as those of the pre-dyeing step along with cosorbents through the holes in the electrodes in order to covalently bind said dye(s) to the surface of the metal oxide, wherein dyeing is carried out between the sealed electrodes at a temperature of from 10 to 70 °C;
l) injecting an electrolyte through the holes in the electrodes, either simultaneously with the dye(s) or not more than 10 minutes after the dye;
m) sealing the holes in the electrodes with glue or with a thermoplastic polymer;
n) providing an external connection between the two electrodes for electron transport.

The steps of cleaning, activation and platinisation can advantageously be carried out in a continuous "roll-to-roll" process, very useful for industrial applications.

The present invention also discloses a continuous process for industrially producing dye-sensitised solar cells in the form of a roll or sheet that comprises the steps of:
a) providing a first electrode as a moving roll or sheet of substrate, preferably a roll;
b) providing a first roller or system of rollers each coated with metal oxide or a first dispenser or system of dispensers for printing said metal oxide continuously on the central portion of the substrate;
c) sintering the printed metal oxide by thermal treatment, followed by cooling;
d) providing a second roller coated with sealant or second dispenser for applying said sealant on the substrate, on the same side as the metal oxide paste and on each side of said metal oxide paste; providing a second electrode as a moving roll or sheet of transparent substrate which has been previously coated with transparent conducting oxide and platinum or carbon and has been previously pierced with holes so as to form perforations;
e) optionally pre-dyeing the metal oxide by applying a dye solution bringing together the first electrode of step d) and the second electrode of step d) and applying pressure and/or heat to seal said two electrodes;
f) injecting the dye(s) and cosorbent into the perforations provided through the second electrode;
g) injecting the electrolyte through the perforations provided in the second electrode simultaneously with the injection of the dye(s) and cosorbent of step g) or within 10 minutes at the most after the dye(s), preferably at the same time as the dye(s);
h) sealing the perforations in the second electrode;
i) storing a roll or sheet of the dye-sensitised solar cells for subsequent retrieval or cutting the continuous roll of the dye-sensitised solar cells into individual solar cells for storage and subsequent retrieval.

The dye-sensitised solar cells prepared according to the preferred method here-above have a higher efficiency and fill factor than those of the prior art.

Solar panels can then be prepared by connecting individual solar cells.

### EXAMPLES.

### Comparitive example 1.

Sandwich-type DSC cells devices were prepared following the structure described in Figure 1. Commercial, screen printed titania working photoelectrodes (Dyesol Ltd, Australia) were heated to a temperature of 450 ºC for a period of time of 30 minutes and then cooled to a temperature of 100 ºC, ready for dyeing. The working electrodes were glass coated with fluorine tin oxide-coated glass with resistance of 15 Ω/cm². The thin films of titania had a thickness of approximately 12 µm with a working area of approximately 0.88 cm².

The metal oxide films were dipped into ethanolic dye solution containing the di-ammonium salt of *cis*-bis(4,4'-dicarboxy-2,2'-bipyridine)dithiocyanato ruthenium(II), commonly known as N719 (1 mM) for time periods of 18-24 h. After dyeing, a thermoplastic polymer gasket (Surlyn® from Du Pont) was placed around the photoelectrode and a commercial counter electrode (Dyesol Ltd, Australia) was placed on top and the electrodes sealed together at a temperature of 120 °C. The commercial counter electrode was transparent-conducting glass coated electrode with a platinum layer which had been activated at a temperature of 400 ºC for a period of time of 30 minutes prior to being used. A commercial liquid electrolyte containing iodine/tri-iodide in nitrile solvent (Dyesol Ltd, Australia) was added through a hole in the counter electrode which was then sealed using thermoplastic polymer (Surlyn®). Table 1 displays typical efficiency data and fill factors along with the open circuit voltage V_{oc} and the short circuit current J_{sc} for comparative cells having also a working area of approximately 0.88 cm².

**TABLE 1.**

| **Substrate** | **Illumination side** | **Temp for Pt** | **Sun level** | **V_{oc} (V)** | **J_{sc} (mA cm⁻²)** | **Fill factor (%)** | **Efficiency (%)** |
|---|---|---|---|---|---|---|---|
| FTO-Glass | Titania | 400 ºC | 1.0 | 0.68 | 9.65 | 0.49 | 4.5 |
| | Pt CE | | 1.0 | 0.71 | 7.21 | 0.57 | 4.0 |
| ITO-PEN | N/A | 400 ºC | 1.0 | 0 | 0 | 0 | 0 |
| ITO-PET | N/A | 400 ºC | 1.0 | 0 | 0 | 0 | 0 |

Data shown in Table 1 is for DSC devices prepared using titania photoelectrodes. PEN = polyethylene nathphthalene and PET = polyethylene terephthalate. Illumination side is not applicable for plastic substrates as they are not thermally stable enough to survive platinisation at 400 ºC.

It must be noted that in the conventional method wherein platinisation is carried out at a temperature of about 450 ºC, a thermoplastic polymer cannot be used to prepare the counter electrode because it would be destroyed by the high temperature treatment. Hence the efficiencies quoted in Table 1 are zero.

### Examples according to the invention.

### Example 1.

Sandwich-type DSC cells devices were prepared following the structure described in Figure 1. Commercial, screen printed titania working photoelectrodes (Dyesol Ltd, Australia) were heated to a temperature of 450 ºC for a period of time of 30 minutes and then cooled down to a temperature of 100 ºC, ready for dyeing. The working electrodes were coated with fluorine tin oxide-coated glass with resistance of 15 Ω/cm². The thin films of titania had a thickness of approximately 12 µm with a working area of 0.88 cm².

The metal oxide films were dipped into ethanolic dye solution containing the di-ammonium salt of *cis*-bis(4,4'-dicarboxy-2,2'-bipyridine)dithiocyanato ruthenium(II), commonly known as N719 (1 mM) for time periods of 18-24 h. After dyeing, a thermoplastic polymer gasket (Surlyn® from Du Pont) was placed around the photoelectrode and a TCO-coated counter electrode which has been coated with platinum was placed on top and the electrodes sealed together at a temperature of 120 °C. The commercial counter electrode was commercial transparent-conducting polymer (PEN from CP Films Ltd). The TCO-coated PEN polymer was first cleaned in a solution of ammonia and hydrogen peroxide in distilled water at a temperature of 70ºC for a period of time of 3 minutes. The TCO surface was then activated with a 1:2 (v/v) solution of water and isopropanol containing PdCl₂ and HCI for 5 mins. Hydrogen gas was then bubbled through a solution of isopropanol for a period of time of 30 s and the PdCl₂ coated substrate was dipped into the hydrogen containing ispropanol solution for a period of time of 3 minutes in order to reduce Pd²⁺ to Pd. Finally, the Pd coated substrate was dipped into an aqueous solution of potassium hexachloroplatinate and hydrogen gas bubbled through this solution from for a period of time of 1 minute and then left to stand for a period of time of 3 minutes prior to washing in deionised water and drying in air. A commercial liquid electrolyte containing iodine/tri-iodide in nitrile solvent (Dyesol Ltd, Australia) was added through a hole in the counter electrode which was then sealed using thermoplastic polymer (Surlyn®). Table 2 displays typical efficiency data and fill factors along with the V_{oc} and J_{sc} for comparative cells having also a working area of approximately 0.88 cm².

**TABLE 2.**

| **Substrate** | **Illumination side** | **Max temp. for Pt** | **Sun level** | **V_{oc} (V)** | **J_{sc} (mA cm⁻²)** | **Fill factor (%)** | **Efficiency (%)** |
|---|---|---|---|---|---|---|---|
| FTO-Glass | Titania | 100ºC | 1.0 | 0.75 | 2.95 | 0.18 | 0.5 |
| | PtCE | | 1.0 | 0.76 | 0.41 | 0.24 | 0.2 |
| ITO-PEN | Pt CE | 100 ºC | 1.0 | 0.6 | 10.14 | 0.44 | 3.6 |
| ITO-PET | Titania | 100 ºC | 1.0 | 0.81 | 9.16 | 0.50 | 4.2 |
| | Pt CE | 100 ºC | 1.0 | 0.81 | 6.95 | 0.56 | 3.6 |

In Table 2, illumination side = titania means that the light is striking the cell from the titanium side generally called the 'normal side'. Illumination side = Pt CE means that the light is striking the cell from the counter-electrode side and is generally called the 'reverse side'.

### Example 2.

In further examples the inventive method was applied to prepare sandwich-type DSSC cells devices following the structure described in Figure 1. Titania photo-electrodes were prepared by doctor blading two layers of a commercial titania paste (Dyesol Ltd, Australia) onto TEC glass with heating to a temperature of 450 ºC for 30 minutes for each layer. In some examples, a layer of large scattering titania particles of the order of 400 nm was also added. Each titania layer was treated with TiCl₄ solution and re-heated to 450 ºC before a final cooling down to 100 ºC, ready for dyeing. The working electrodes were coated with fluorine tin oxide-coated glass with resistance of 15 Ω/cm². The thin films of titania had a thickness of approximately 12 µm with a working area of 0.92-0.94 cm².

The metal oxide films were dipped into ethanolic dye solution containing the di-ammonium salt of *cis*-bis(4,4'-dicarboxy-2,2'-bipyridine)dithiocyanato ruthenium(II), commonly known as N719 (1 mM) for time periods of 18-24 h. After dyeing, a thermoplastic polymer gasket (Surlyn® from Du Pont) was placed around the photoelectrode and a TCO-coated counter electrode which had been coated with platinum was placed on top and the electrodes sealed together at a temperature of 120 °C. The commercial counter electrode was commercial transparent-conducting polymer (PET from Optical Filters Ltd). The TCO-coated PET polymer was first cleaned in a solution of ammonia and hydrogen peroxide in distilled water at a temperature of 70ºC for a period of time of 3 minutes. The TCO surface was then activated with a 1:2 (v/v) solution of water and isopropanol containing PdCl₂ and HCI for 5 mins. Hydrogen gas was then bubbled through a solution of isopropanol for a period of time of 60 s and the PdCl₂ coated substrate was dipped into the hydrogen containing is propanol solution for a period of time of 3 minutes in order to reduce Pd²⁺ to Pd. The dipping in the palladium solution and the hydrogen solution was then repeated. Finally, the Pd coated substrate was dipped into an aqueous solution of potassium hexachloroplatinate and hydrogen gas bubbled through this solution from for a period of time of 90 s and then left to stand for a period of time of 4 minutes prior to washing in deionised water and drying in air. A commercial liquid electrolyte containing iodine/tri-iodide in nitrile solvent (Dyesol Ltd, Australia) was added through a hole in the counter electrode which was then sealed using thermoplastic polymer (Surlyn®). Table 3 shows efficiency data and fill factors along with the V_{oc} and J_{sc} for comparative cells having a working area of 0.92 cm². The DSC devices in Table 3 were manufactured from small pieces of ITO-coated PET film (3 x 1.5 cm) which had been platinised in small containers. These samples were used as counter electrodes in DSC devices with FTO-coated glass titania photo-electrodes to assess the reproducibility and consistency of the method between electrodes.

**TABLE 3.**

| **Device** | **Illumination side** | **Max temp. for Pt** | **Sun level** | **V_{oc} (V)** | **J_{sc} (mA cm⁻²)** | **Fill factor (%)** | **Efficiency (%)** |
|---|---|---|---|---|---|---|---|
| Two layers of titania plus a scattering layer | | | | | | | |
| A | Titania | 100 ºC | 1.0 | 0.72 | 15.73 | 0.47 | 5.2 |

| Two layers of titania | | | | | | | |
|---|---|---|---|---|---|---|---|
| B | Titania | 100 ºC | 1.0 | 0.75 | 14.33 | 0.42 | 4.4 |
| | Pt CE | | 1.0 | 0.74 | 11.00 | 0.47 | 3.7 |
| C | Titania | 100 ºC | 1.0 | 0.73 | 14.08 | 0.50 | 5.0 |
| | Pt CE | | 1.0 | 0.71 | 11.68 | 0.52 | 4.3 |
| D | Titania | 100 ºC | 1.0 | 0.74 | 14.40 | 0.47 | 4.9 |
| | Pt CE | | 1.0 | 0.73 | 11.96 | 0.51 | 4.3 |

In Table 3, illumination side = titania means that the light is striking the cell from the titanium side generally called the 'normal side'. Illumination side = Pt CE means that the light is striking the cell from the counter-electrode side and is generally called the 'reverse side'.

Table 4 shows efficiency data and fill factors along with the V_{oc} and J_{sc} for comparative cells having a working area of approximately 0.94 cm². The DSC devices in Table 4 were manufactured from a large piece of ITO-coated PET film (15 x 16 cm) from which sub-samples had been cut. These smaller sub-samples were used as counter electrodes in DSC devices with FTO-coated glass titania photo-electrodes to assess the reproducibility and consistency of the method across a larger sample area.

**TABLE 4.**

| **Device** | **Illumination side** | **Max temp. for Pt** | **Sun level** | **V_{oc} (V)** | **J_{sc} (mA cm⁻²)** | **Fill factor (%)** | **Efficiency (%)** |
|---|---|---|---|---|---|---|---|
| E | Titania | 100 ºC | 1.0 | 0.69 | 12.44 | 0.47 | 4.1 |
| | PtCE | | 1.0 | 0.65 | 9.51 | 0.52 | 3.3 |
| F | Titania | 100 ºC | 1.0 | 0.74 | 13.17 | 0.46 | 4.6 |
| | Pt CE | | 1.0 | 0.69 | 10.40 | 0.50 | 3.7 |
| G | Titania | 100 ºC | 1.0 | 0.74 | 10.95 | 0.49 | 4.0 |
| | Pt CE | | 1.0 | 0.71 | 9.81 | 0.50 | 3.5 |

In Table 4, illumination side = titania means that the light is striking the cell from the titanium side generally called the 'normal side'. Illumination side = Pt CE means that the light is striking the cell from the counter-electrode side and is generally called the 'reverse side'.

It can be seen that the efficiency, V_{oc} and J_{sc} of dye sensitised solar cells of which the counter electrodes were prepared according to the present invention is systematically higher than that of conventional cells prepared at the same temperature.

## Claims

1. A method for platinisation of the counter-electrode of a dye-sensitised solar cell that comprises the steps of:
a) providing a counter electrode prepared from an electro-conducting substrate;
b) coating the counter electrode of step a) with one or more layers of a transparent conducting oxide;
c) cleaning the counter-electrode of step b) with an organic solvent selected from acetone, ethanol or diethyl ether or a cleaning solution selected from aqueous solutions of hydrochloric acid, ammonium hydroxide, sodium hydroxide, potassium hydroxide or ammonia / hydrogen peroxide;
d) activating the counter electrode of step c) with a solution containing a metal salt and reducing said metal salt on the counter electrode surface;
e) treating the electrode of step d) with aqueous platinum solution of either Pt (II) or Pt (IV), said solution having a pH of at least 3;
f) adding a reducing agent to the treated electrode of step e) and wherein the reduction of the aqueous platinum solution is carried out at a temperature of from room temperature to at most 100 °C;
g) retrieving a platinum coated counter electrode, **characterised in that** all the steps are carried out at a temperature of less than 100 °C.

2. The method of claim 1 wherein a titania scattering layer is added between step b) and step c), with titania particles having a diameter ranging between 300 and 500 nm.

3. The method of claim 1 or claim 2 wherein the cleaning solution of step c) is selected from ammonia / hydrogen peroxide / distilled water.

4. The method of any one of the preceding claims further comprising pre-treating the counter electrode of step c), wherein said pre-treatment is carried out with an aqueous tin (II) chloride solution or an aqueous zinc (II) solution.

5. The method of any one of the preceding claims wherein the metal salt of activating step d) is selected from NiCl₂, CuCl₂, PdCl₂.

6. The method of any one of the preceding claims wherein the reducing agent in step d) is selected from citrate, phosphate, borohydride, hydride, hydrogen or thiosulfate.

7. The method of any one of the preceding claims wherein the platinum solution of step e) is selected from potassium hexachloroplatinate (II), potassium hexachloroplatinate (IV), hexachloroplatinic acid (IV), hexachloroplatinate, or a hexachloroplatinate salt.

8. The method of claim 7 wherein the platinum solution is potassium hexachloroplatinate (IV).

9. The method of any one of the preceding claims wherein the reducing agent used in step f) is selected from hydrazine, phosphate hydride, hydrogen or borohydride.

10. The method of any one of the preceding claims wherein the substrates are cleaned, activated, reduced and chemicals are deposited thereupon by dipping or spraying followed by wiping to remove excess solution.

11. The method of any one of the preceding claims wherein heating is carried out by exposure to heat and / or ultra-violet radiation.

12. The method of any one of claims 1 to 10 wherein heating is carried out by exposure to heat and / or microwave radiation.

13. The method of any preceding claim, wherein step c) is carried out with ultra-sound.

## Patentansprüche

1. Verfahren zur Platinierung der Gegenelektrode einer farbstoffsensibilisierten Solarzelle, das folgende Schritte umfasst:
a) Bereitstellen einer Gegenelektrode aus einem elektrisch leitenden Substrat;
b) Beschichten der Gegenelektrode aus Schritt a) mit einer oder mehreren Schichten eines transparenten leitenden Oxids;
c) Reinigen der Gegenelektrode aus Schritt b) mit einem aus Aceton, Ethanol oder Diethylether ausgewählten organischen Lösungsmittel oder einer aus wässrigen Lösungen von Salzsäure, Ammoniumhydroxid, Natriumhydroxid, Kaliumhydroxid oder Ammoniak/Wasserstoffperoxid ausgewählten Reinigungslösung;
d) Aktivieren der Gegenelektrode aus Schritt c) mit einer ein Metallsalz enthaltenden Lösung und Reduzieren des Metallsalzes auf der Oberfläche der Gegenelektrode;
e) Behandeln der Elektrode aus Schritt d) mit wässriger Platinlösung von entweder Pt(II) oder Pt(IV), wobei die Lösung einen pH-Wert von mindestens 3 aufweist;
f) Zugeben eines Reduktionsmittels zu der behandelten Elektrode aus Schritt e) und wobei die Reduktion der wässrigen Platinlösung bei einer Temperatur von Raumtemperatur bis höchstens 100 °C durchgeführt wird;
g) Gewinnen einer mit Platin beschichteten Gegenelektrode, **dadurch gekennzeichnet, dass** alle Schritte bei einer Temperatur von weniger als 100 °C durchgeführt werden.

2. Verfahren nach Anspruch 1, bei dem zwischen Schritt b) und Schritt c) eine Titandioxid-Streuschicht mit Titandioxidteilchen mit einem Durchmesser im Bereich zwischen 300 und 500 nm zugefügt wird.

3. Verfahren nach Anspruch 1 oder Anspruch 2, bei dem die Reinigungslösung von Schritt c) aus Ammoniak/Wasserstoffperoxid/destilliertem Wasser ausgewählt wird.

4. Verfahren nach einem der vorhergehenden Ansprüche, ferner umfassend das Vorbehandeln der Gegenelektrode aus Schritt c), wobei die Vorbehandlung mit einer wässrigen Zinn(II)-chlorid-Lösung oder einer wässrigen Zink(II)-Lösung durchgeführt wird.

5. Verfahren nach einem der vorhergehenden Ansprüche, bei dem das Metallsalz des Aktivierungsschritts d) aus NiCl₂, CuCl₂, PdCl₂ ausgewählt wird.

6. Verfahren nach einem der vorhergehenden Ansprüche, bei dem das Reduktionsmittel in Schritt d) aus Citrat, Phosphat, Borhydrid, Hydrid, Wasserstoff oder Thiosulfat ausgewählt wird.

7. Verfahren nach einem der vorhergehenden Ansprüche, bei dem die Platinlösung von Schritt e) aus Kalium-hexachloroplatinat(II), Kaliumhexachloroplatinat(IV), Hexachloroplatinsäure(IV) Hexachloroplatinat oder einem Hexachloroplatinatsalz ausgewählt wird.

8. Verfahren nach Anspruch 7, bei dem es sich bei der Platinlösung um Kaliumhexachloroplatinat(IV) handelt.

9. Verfahren nach einem der vorhergehenden Ansprüche, bei dem das in Schritt f) verwendete Reduktionsmittel aus Hydrazin, Phosphathydrid, Wasserstoff oder Borhydrid ausgewählt wird.

10. Verfahren nach einem der vorhergehenden Ansprüche, bei dem man die Substrate reinigt, aktiviert und reduziert und Chemikalien darauf abscheidet, indem man sie eintaucht oder besprüht und anschließend überschüssige Lösung abwischt.

11. Verfahren nach einem der vorhergehenden Ansprüche, bei dem das Erhitzen durch Einwirkung von Wärme und/oder Ultraviolettstrahlung durchgeführt wird.

12. Verfahren nach einem der Ansprüche 1 bis 10, bei dem das Erhitzen durch Einwirkung von Wärme und/oder Mikrowellenstrahlung durchgeführt wird.

13. Verfahren nach einem der vorhergehenden Ansprüche, bei dem Schritt c) mit Ultraschall durchgeführt wird.

## Revendications

1. Procédé de platinage de la contre-électrode d'une cellule solaire à colorant qui comprend les étapes consistant à :
a) se procurer une contre-électrode préparée à partir d'un substrat électroconducteur ;
b) revêtir la contre-électrode de l'étape a) avec une ou plusieurs couches d'un oxyde conducteur transparent ;
c) nettoyer la contre-électrode de l'étape b) avec un solvant organique choisi parmi l'acétone, l'éthanol ou l'éther diéthylique ou une solution de nettoyage choisie parmi les solutions aqueuses d'acide chlorhydrique, d'hydroxyde d'ammonium, d'hydroxyde de sodium, d'hydroxyde de potassium ou d'ammoniac / peroxyde hydrogène ;
d) activer la contre-électrode de l'étape c) avec une solution contenant un sel métallique et réduire ledit sel métallique sur la surface de la contre-électrode ;
e) traiter l'électrode de l'étape d) avec une solution aqueuse de platine, soit de Pt (II), soit de Pt (IV), ladite solution ayant un pH d'au moins 3 ;
f) ajouter un réducteur à l'électrode traitée de l'étape e), la réduction de la solution aqueuse de platine étant réalisée à une température allant de la température ambiante à 100 °C maximum ;
g) récupérer une contre-électrode revêtue de platine, **caractérisé en ce que** toutes les étapes sont réalisées à une température inférieure à 100 °C.

2. Procédé de la revendication 1 dans lequel une couche de diffusion en dioxyde de titane est ajoutée entre l'étape b) et l'étape c), avec des particules de dioxyde de titane ayant un diamètre compris entre 300 et 500 nm.

3. Procédé des revendication 1 ou la revendication 2 dans lequel la solution de nettoyage de l'étape c) est choisie à partir d'ammoniac / peroxyde hydrogène / eau distillée.

4. Procédé de l'une quelconque des revendications précédentes comprenant en outre le prétraitement de la contre-électrode de l'étape c), ledit prétraitement étant réalisé avec une solution aqueuse de chlorure d'étain (II) ou une solution aqueuse de zinc (II).

5. Procédé de l'une quelconque des revendications précédentes dans lequel le sel métallique de l'étape d'activation d) est choisi parmi NiCl₂, CuCl₂, PdCl₂.

6. Procédé de l'une quelconque des revendications précédentes dans lequel le réducteur à l'étape d) est choisi parmi le citrate, le phosphate, le borohydrure, l'hydrure, l'hydrogène ou le thiosulfate.

7. Procédé de l'une quelconque des revendications précédentes dans lequel la solution de platine de l'étape e) est choisie parmi l'hexachloroplatinate de potassium (II), l'hexachloroplatinate de potassium (IV), l'acide hexachloroplatinique (IV), l'hexachloroplatinate, ou un sel d'hexachloroplatinate.

8. Procédé de la revendication 7 dans lequel la solution de platine est l'hexachloroplatinate de potassium (IV).

9. Procédé de l'une quelconque des revendications précédentes dans lequel le réducteur utilisé à l'étape f) est choisi parmi l'hydrazine, l'hydrure de phosphate, l'hydrogène ou le borohydrure.

10. Procédé de l'une quelconque des revendications précédentes dans lequel les substrats sont nettoyés, activés, réduits, et des produits chimiques sont déposés par-dessus par trempage ou pulvérisation puis essuyés pour retirer l'excès de solution.

11. Procédé de l'une quelconque des revendications précédentes dans lequel un chauffage est réalisé par exposition à de la chaleur et/ou un rayonnement ultraviolet.

12. Procédé de l'une quelconque des revendications 1 à 10 dans lequel un chauffage est réalisé par exposition à de la chaleur et/ou un rayonnement micro-ondes.

13. Procédé d'une quelconque revendication précédente, dans lequel l'étape c) est réalisée avec des ultrasons.
